# EUROPEAN PATENT SPECIFICATION

(11) **EP 2 898 545 B1**
(45) Date of publication and mention of the grant of the patent: **14.11.2018**
(21) Application number: 13756043.9
(22) Date of filing: 22.08.2013
(51) Int. Cl.: H01L 31/18

(54) **METHOD FOR FABRICATING SILICON PHOTOVOLTAIC CELLS**
HERSTELLUNGSVERFAHREN FÜR AUF SILIZIUM-BASIERTE SOLARZELLEN
PROCÉDÉ DE FABRICATION DE CELLULES PHOTOVOLTAÏQUES AU SILICIUM

(30) Priority: 24.09.2012 US 201261704954 P
(43) Date of publication of application: 29.07.2015
(73) Proprietor: IMEC VZW, 3001 Leuven (BE)
(72) Inventor: KUZMA FILIPEK, Izabela, 3001 Leuven (BE)
(74) Representative: DenK iP
(86) International application number: PCT/EP2013/067456
(87) International publication number: WO 2014/044482

(56) References cited:
- KR-B1- 101 149 891
- US-A1- 2008 128 268
- US-A1- 2009 223 549
- US-A1- 2012 142 140
- TOUS L ET AL: "Large Area Copper Plated Silicon Solar Cell Exceeding 19.5% Efficiency", ENERGY PROCEDIA, vol. 21, 25 October 2011 (2011-10-25), - 26 October 2011 (2011-10-26), pages 58-65, XP028493618, ISSN: 1876-6102, DOI: 10.1016/J.EGYPRO.2012.05.008 [retrieved on 2012-06-15]

## Description

### Technical field

The disclosed technology relates to methods for fabricating silicon photovoltaic cells, more in particular to methods for front side and rear side metallization of silicon photovoltaic cells, and to silicon photovoltaic cells thus obtained.

### Background art

Several approaches for front side metallization and back side metallization of for example passivated emitter and rear cells (PERC)-type photovoltaic cells are known.

In a typical process flow, after providing a passivation layer at the rear side of the cells and an antireflection coating at the front side of the cells, openings are made in the rear side passivation layer at locations where contacts are to be provided to the underlying silicon. An Al layer is then deposited on the rear side (e.g. by screen printing, evaporation, sputtering) and a patterned Ag paste is screen printed on top of the antireflection coating. The cells are then typically fired or annealed at a relatively high temperature with a peak temperature of at least 835ºC (e.g. in the range between about 835ºC and 950ºC or in between about 835ºC and 950ºC), such that the patterned Ag paste penetrates through the antireflection coating to the underlying silicon and forms front side metal contacts. In the same firing process good Al contacts and back surface field (BSF) regions are formed at the rear side. This process is referred to as a co-firing process.

Other process flows are known wherein the front side contacts are Cu based. For example, a Ni/Cu stack can be used for the front side contacts. In such process flows only the rear contacts need to be fired. This is typically done at a peak temperature in the range between 700ºC and 900ºC. The formation of good contacts at the front side is obtained afterwards in a separate annealing step, for example at a temperature in the order of 400ºC, leading to the formation of a Ni silicide. In such an approach, the rear side contacts are fired (annealed) twice. This may increase the risk of metal spiking through the rear side dielectric layer.

The use of a Ni silicide as a contacting material underneath the Cu offers clear advantages of reduced series and contact resistance, and formation of a barrier against Cu diffusion into the silicon. In a photovoltaic cell fabrication process, the silicide can be defined in narrow openings formed in the antireflection coating for example by laser ablation. This allows forming a front contact pattern with fingers that are significantly narrower than what can be achieved with screen printing techniques.

A typical metallisation process sequence with Cu-based front side contacts, starting from a partially processed photovoltaic cell having a SiNₓ antireflection coating at the front side and a dielectric stack (passivation) at the rear side, comprises the following steps: local laser ablation of the dielectric stack at the rear side; next Al deposition at the rear side; afterwards firing of the Al rear contacts; local laser ablation of the antireflection coating at the front side; next front side Ni sputtering or electroplating; afterwards annealing for forming a nickel silicide (silicidation); and then plating, e.g. barrier plating, Cu plating and Ag plating.

US 2012/0142140 discloses a method for the fabrication of solar cells comprising forming a collector electrode on a metallic (e.g. nickel) layer on a front surface of a silicon substrate. Aluminum ink may be printed as a back contact electrode. The front grid electrodes and back contact may be co-fired.

### Summary of the disclosure

Certain inventive aspects relate to fabrication methods for silicon photovoltaic cells with plated front side contacts, wherein the number of process steps is reduced as compared to prior art methods. Certain inventive aspects relate to fabrication methods for silicon photovoltaic cells comprising co-firing of front side contacts and rear side contacts, wherein the co-firing temperature is reduced as compared to prior art methods.

One inventive aspect relates to a method for the fabrication of crystalline silicon photovoltaic cells, the method comprising: providing a dielectric layer, e.g. antireflection coating, on a front surface of a silicon substrate; forming openings through the dielectric layer, e.g. antireflection coating, at predetermined locations where front side contacts are to be formed for respective photovoltaic cells; afterwards providing a first metal layer on the front side of the substrate; providing a second metal layer on the rear side of the silicon substrate; and afterwards annealing with a peak annealing temperature, the first metal layer being selected to enable good silicidation or silicide formation at the peak annealing temperature, to thereby form rear side contacts and Back Surface Field regions at the rear side of the cells and to thereby simultaneously form a silicide at the front side at locations where the first metal layer is in direct contact with the silicon substrate; and thereafter plating at least one further metal layer using said silicide as a seed layer, thereby forming front side contacts.

The peak annealing temperature is preferably in the range between 570ºC and 830ºC or between about 570ºC and 830ºC, e.g. between 660ºC and 800ºC or between about 660ºC and 800ºC. Preferably, the peak annealing temperature is below 800°C.

The dielectric layer can be a single dielectric layer, such as a SiNₓ layer, a SiOₓ layer or an AlOₓ layer, or the dielectric layer can be a stack of dielectric layers, such as a stack comprising AlOₓ and/or SiNₓ and/or SiOₓ. The dielectric layer may contain hydrogen and can provide good front surface passivation. Its thickness can be selected to function as an antireflection coating. The front surface of the silicon substrate can be textured.

Forming openings through the dielectric layer can be done by means of laser ablation or by other suitable methods known by a person skilled in the art, such as by photolithography followed by dry or wet etching, by screen printing of a polymer mask followed by dry or wet etching, or by any other suitable method known by a person skilled in the art.

The first metal layer is selected to enable the formation of a metal silicide at the peak annealing temperature. The first metal layer can for example be a transistion metal layer such as a Co layer or a Ti layer or it can comprise a mixture of metals (such asTiW, TiN or TaN). It can for example be provided by PVD, CVD, electroplating or electroless plating.

The second metal layer can for example be an Al layer, e.g. provided by physical vapor deposition (PVD), screen printing or evaporation, or a layer comprising Al, such as an AISi layer. However, the present disclosure is not limited thereto and other metals can be used for forming the second metal layer.

According to certain embodiments, the method further comprises providing a second dielectric layer on the rear side of the photovoltaic cell and locally opening the second dielectric layer on the rear side, for instance by means of a laser treatment, before providing a second metal layer on the rear side of the silicon substrate.

During annealing (or co-firing) good rear side contacts and BSF regions are formed at the rear side of the cells, and simultaneously a silicidation reaction occurs at the front side at locations where the first metal layer is in direct contact with the silicon substrate, e.g., at the location of the openings through the dielectric layer.

After annealing, non-reacted residues of the first metal layer may be removed and the remaining metal silicide layer may be used as a seed layer for a subsequent plating step, such as a Cu or Ni plating step.

As compared to prior art methods wherein Ni silicides are used as a seed layer at the front side, it is an advantage of using other metals such as Ti that these metals form more stable silicides and have a lower diffusion rate into silicon. This results in a reduced risk of junction spiking, allowing the use of shallow emitter regions.

As compared to a method using a nickel silicide at the front side, it is an advantage of one inventive aspect that a single annealing step or co-firing step can be used for forming silicides at the front side of the cells and forming good rear side contacts and BSF regions at the rear side of the cells. Therefore the need for two separate annealing steps can be avoided and the number of process steps is reduced as compared to such prior art methods. This annealing step or co-firing step can be done at moderate temperatures, e.g. lower than 800°C or lower than about 800ºC.

As compared to a method using co-firing with screen printed front side contacts, it is an advantage of one inventive aspect that the co-firing temperature can be reduced from at least about 835ºC in case of Ag screen printed front side contacts to 660°C or to about 660ºC when using on the rear side e.g. an Al layer as a second metal layer or even to 570°C or about 570ºC when using e.g. an AISi layer as a second metal layer.

It is an advantage of one inventive aspect that the co-firing step is performed after front side laser ablation. As a consequence, hydrogen released from the dielectric layer, e.g. SiNₓ:H antireflection coating, during the co-firing or annealing step not only passivates the Si-SiNₓ interface with hydrogen but also the regions that may be damaged by the laser ablation. It is known that PECVD SiNₓ deposited at low temperatures (e.g., temperatures in between 300°C and 400°C, or inbetween about 300ºC and 400ºC) incorporates a large amount of hydrogen (up to 30-40% or up to about 30-40%). During annealing or co-firing, hydrogen is released from the SiNₓ layer and may improve surface passivation. The annealing or co-firing can also annihilate laser ablation damage, at least partially.

During annealing or co-firing, the SiNₓ layer densifies. It is an advantage of one inventive aspect that the laser ablation step of the antireflection coating is done before contact firing, e.g., before SiNₓ layer densification. Therefore the ablation of the antireflection coating is facilitated by the lower density of the layer as deposited compared to the layer density after firing. This results in a more uniform and more complete ablation, leading to better metal coverage and hence lower contact resistances and higher fill factors.

It is an advantage of one inventive aspect that a good cleaning of the substrate can be performed after front side laser ablation, because such cleaning can be done before the presence of any metal layer. Therefore, there are fewer restrictions related to cleaning methods and cleaning agents that can be used, and there is no need for providing protection layers.

Certain objects and advantages of various inventive aspects have been described herein above. Of course, it is to be understood that not necessarily all such objects or advantages may be achieved in accordance with any particular embodiment of the disclosure. Thus, for example, those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure. The disclosure, both as to organization and method of operation, together with features and advantages thereof, may best be understood by reference to the following detailed description when read in conjunction with the accompanying drawings.

### Brief description of the drawings

Figure 1 schematically illustrates an example of a fabrication method in accordance with one embodiment, for a PERC-type silicon photovoltaic cell.
Figure 2 shows measured pFF values of PERC cells fabricated in accordance with one embodiment, as a function of peak annealing temperature. Filled squares represent values measured after silicide formation and before plating; open squares represent values measured after subsequent plating.
Figure 3 shows measured Suns V_{oc} values of PERC cells fabricated in accordance with one embodiment, as a function of peak annealing temperature. Filled squares represent values measured after silicide formation and before plating; open squares represent values measured after subsequent plating.
Figure 4 (a) to (f) further illustrates the process flow of the fabrication method as illustrated in Figure 1.

### Detailed description of preferred embodiments

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure. While the present disclosure will be described with respect to particular embodiments and with reference to certain drawings, the disclosure is not limited hereto. The drawings included and described herein are schematic and are not limiting the scope of the disclosure. It is also noted that in the drawings, the size of some elements may be exaggerated and, therefore, not drawn to scale for illustrative purposes.

Furthermore, the terms first, second, third and the like in the description are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Moreover, the terms top, bottom, over, under and the like in the description are used for descriptive purposes and not necessarily for describing relative positions. It is to be understood that the terms so used are interchangeable under appropriate circumstances and that the embodiments of the disclosure described herein are capable of operation in other orientations than described or illustrated herein.

It is to be noticed that the term "comprising" should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

In the context of the present disclosure, the front surface or front side of a photovoltaic cell is the surface or side adapted for being oriented towards a light source and thus for receiving illumination. In case of bifacial photovoltaic cells, both surfaces are adapted to receive impinging light. In such case, the front surface or front side is the surface or side adapted for receiving the largest fraction of the light or illumination. The back surface, back side, rear surface or rear side of a photovoltaic cell is the surface or side opposite to the front surface. The front side of a substrate is the side of the substrate corresponding to the front side of the photovoltaic cell, while the rear side or back side of the substrate corresponds to the back side of the photovoltaic cell.

A method for the fabrication of crystalline silicon photovoltaic cells according to one inventive aspect comprises: providing a dielectric layer, e.g. antireflection coating, on a front surface of a silicon substrate; forming openings through the dielectric layer, e.g. antireflection coating, at predetermined locations where front side contacts are to be formed; afterwards providing a first metal layer, e.g. transition metal layer, on the front side of the silicon substrate; providing a second metal layer, e.g. Al metal layer, on the rear of the silicon substrate; and afterwards annealing with a peak annealing temperature for instance in the range between 570ºC and 830ºC or in between about 570ºC and 830ºC, e.g. between 660ºC and 800ºC or between about 660ºC and 800ºC, the first metal layer being selected for enabling good silicidation at the peak annealing temperature. During annealing or co-firing, good rear side contacts and BSF regions are formed at the rear side of the cells, and simultaneously a silicidation reaction occurs at the front side at locations where the first metal layer is in direct contact with the silicon substrate. The silicide formed during the silicidation reaction is used as a seed layer for plating of at least one further metal layer.

In a method according to one inventive aspect, silicides are formed based on metals other than Ni, wherein the metals are selected based on their silicidation temperature. By selecting metals with a silicidation temperature in the range between about 570ºC and 830ºC, e.g. between about 660ºC and 800ºC, co-firing of front side and rear side contacts can be done and thus the number of process steps can be reduced as compared to prior art methods.

In a method according to one embodiment, various transition metals of the group 4-10 (IUPAC STANDARD) can be used. Mixed metal solutions can be used where high temperature metals and compounds (Ti, Co, TiW) could be tailored by low temperature additives like Pt, Ni in order to result in a silicidation temperature in a predetermined co-firing temperature window leading to a stable silicide.

In a method according to one embodiment, transition metals are used that can form stable silicide layers in similar process windows (temperature, time, firing profile comprising ramp up, stable, peak temperature and ramp down) as the process window suitable for rear side contact formation.

A method according to one embodiment can be used both for the fabrication of cells with full Al rear side contacts and for the fabrication of cells with local Al (and BSF) rear side contacts (such as PERC-type cells).

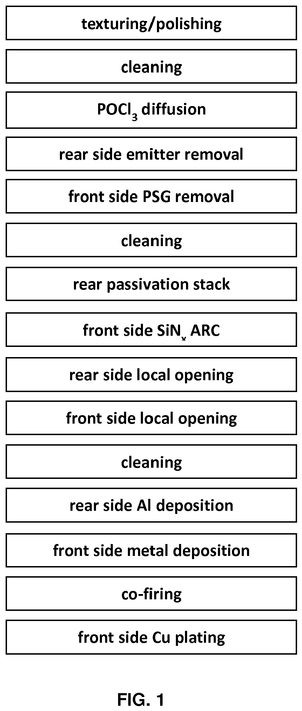

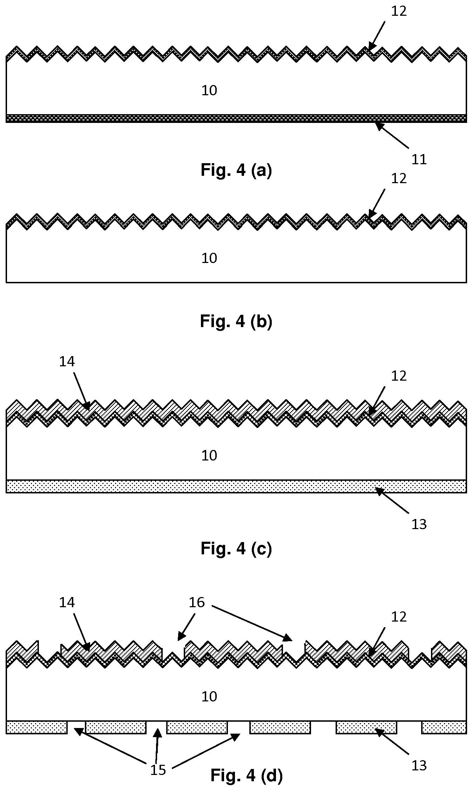

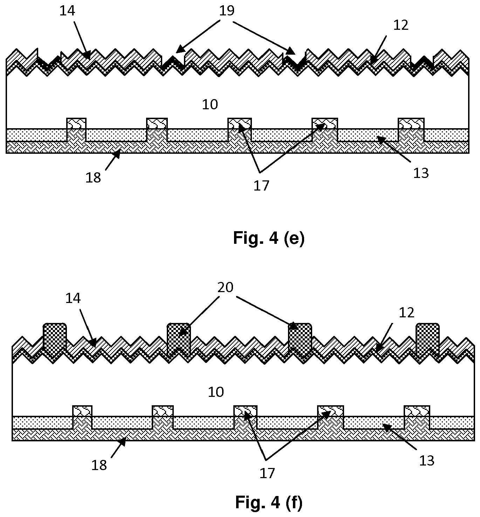

An example of a fabrication method in accordance with one inventive aspect is schematically illustrated in Figure 1, for a PERC-type silicon photovoltaic cell. Figures 4(a) to 4(f) further illustrate the fabrication method by showing the photovoltaic cell in different stages of its fabrication. The fabrication method illustrated in Figure 1 comprises: front side texturing and rear side polishing of a substrate 10 (e.g. crystalline silicon wafer or substrate); performing a cleaning step; emitter diffusion at a temperature in the range between e.g. about 800ºC and 950ºC in a POCl₃ diffusion furnace, resulting in doped region both at the front side (region 12, emitter) and at the rear side (region 11, rear emitter)of the substrate (Fig. 4(a)); removal of the doped (emitter) region at the rear side (Fig. 4(b)); removal of the phosphosilicate glass (PSG) formed during emitter diffusion at the front surface; and performing a cleaning step. Next a passivation stack 13 is provided at the rear side of the cell and an antireflection coating 14 (ARC), e.g. a SiNₓ:H layer, is deposited at the front side (Fig. 4(c)). This is followed by local opening, for example by laser ablation, of the passivation stack at the rear side at locations 15 where rear side contacts are to be formed, and local opening, for example by laser ablation, of the antireflection coating at locations 16 where front side contacts are to be formed (Fig. 4(d)). After the laser ablation steps the wafer is cleaned. A second metal layer 18, for example an Al layer, is then provided at the rear side and a first metal layer 19, such as a Ti layer or a Co layer, is provided at the front side (Fig. 4(e)). Next an annealing step or co-firing step is performed, optionally followed by removal of unreacted metal residues. BSF regions 17 are hereby formed. Finally a front side Cu plating step is performed (Fig. 4(f)) to form contacts 20.

Photovoltaic cells (5 cm x 5 cm) were fabricated on 160 micrometer thick Cz silicon substrates in accordance with the process flow of Figure 1. After texturing of the front surface of the substrates, an emitter with a sheet resistance of about 60 to 80 Ohm per square was formed. At the front side a silicon nitride passivation layer was deposited, the silicon nitride layer also having the function of antireflection coating. At the rear side a stack comprising a PECVD SiOₓ layer and a PECVD SiNₓ layer was deposited. After front side and rear side laser ablation, a cleaning step (2 min, 2% HF) was done. Next a 2 micrometer thick PVD Al layer was deposited at the rear side. As a first metal layer, a 40 nm thick Ti layer was provided at the front side. The co-firing step or annealing step was done by Rapid Thermal Annealing in a nitrogen atmosphere, at different peak temperatures: 600ºC, 615ºC, 620ºC, 625ºC and 630ºC. At the front side this resulted in the formation of a TiSiₓ layer at locations where the Ti layer was in direct contact with the silicon substrate. Unreacted Ti was then removed using a diluted APM (H₂O₂/H₂O/NH₄OH) solution. Next, a light induced Ni plating step was performed using the TiSₓ layer as a seed layer, thereby forming a 1 micrometer thick Ni layer, followed by Cu electroplating of a 9 micrometer thick Cu layer.

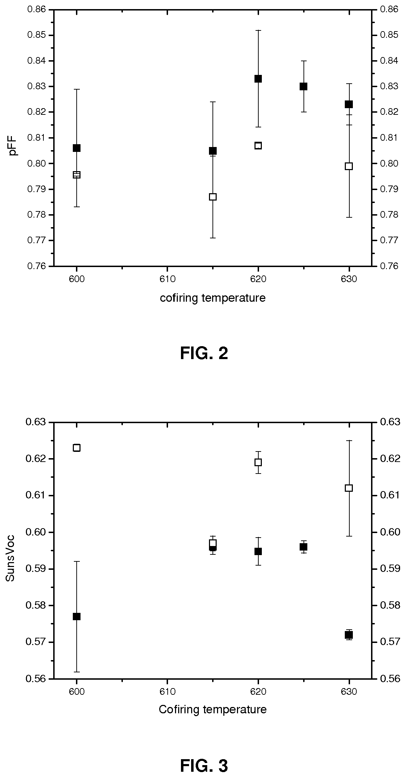

Figure 2 shows the measured pFF values as a function of the annealing peak temperature before the plating steps (filled squares) and after plating (open squares). Figure 3 shows the measured SunsV_{oc} values as a function of the annealing temperature before the plating steps (filled squares) and after plating (open squares). From these measurements it can be concluded that photovoltaic cells with good pFF (around 80% in the examples shown) can be made using a method according to one embodiment. The relatively low open-circuit voltages may be related to a poor Back Surface Field effect at the rear side, due to the relatively low firing temperatures used in these experiments (resulting in a shallow BSF region, about 200 nm deep). The BSF effect can be improved (and thus the open-circuit voltages can be improved) by increasing the peak annealing temperature above the temperatures used in the experiments, e.g., above 630ºC or above about 630ºC, and by tailoring the temperature ramp up profiles.

The foregoing description details certain embodiments of the disclosure. It will be appreciated, however, that no matter how detailed the foregoing appears in text, the disclosure may be practiced in many ways. It should be noted that the use of particular terminology when describing certain features or aspects of the disclosure should not be taken to imply that the terminology is being re-defined herein to be restricted to including any specific characteristics of the features or aspects of the disclosure with which that terminology is associated.

While the above detailed description has shown, described, and pointed out novel features of the disclosure as applied to various embodiments, it will be understood that various omissions, substitutions, and changes in the form and details of the device or process illustrated may be made by those skilled in the technology without departing from the scope of the disclosure.

## Claims

1. A method for the fabrication of crystalline silicon photovoltaic cells, the method comprising:
- providing a dielectric layer (14) on a front surface of a silicon substrate (10);
- forming openings through the dielectric layer (14), at predetermined locations (16) where front side contacts (20) are to be formed for respective photovoltaic cells; and
- thereafter;
∘ providing a first metal layer (19) on the front side of the substrate; and
∘ providing a second metal layer (18) on the rear side of the silicon substrate; and
- thereafter, annealing with a peak annealing temperature and the first metal layer (19) being selected to enable silicide formation at the peak annealing temperature, to thereby form rear side contacts and Back Surface Field regions (17) at the rear side of the cells, and to thereby simultaneously form a silicide at the front side at locations where the first metal layer is in direct contact with the silicon substrate; and
- thereafter, plating at least one further metal layer using said silicide as a seed layer, thereby forming front side contacts (20).

2. A method according to claim 1, wherein said peak annealing temperature is between 570ºC and 830ºC.

3. A method according to claim 2, wherein said peak annealing temperature is below 800°C.

4. A method according to any of the previous claims, wherein said dielectric layer (14) is or comprises an antireflection coating.

5. A method according to any of the previous claims, wherein said dielectric layer (14) is a single dielectric layer and comprises a SiNₓ layer, a SiOₓ layer or an AlOₓ layer.

6. A method according to any of the previous claims 1 to 4, wherein said dielectric layer (14) is a stack of dielectric layers comprising AlOₓ and/or SiNₓ and/or SiOₓ.

7. A method according to any of the previous claims, wherein said dielectric layer (14) comprises hydrogen and provides front surface passivation.

8. A method according to any of the previous claims, comprising forming openings through the dielectric layer (14) by means of laser ablation.

9. A method according to any of the previous claims, wherein the first metal layer (19) is a transition metal layer.

10. A method according to any of the previous claims 1 to 7, wherein said first metal layer (19) comprises TiW, TiN or TaN.

11. A method according to any of the previous claims, wherein said second metal layer (18) comprises Aluminum.

12. A method according to any of the previous claims, further comprising removing non-reacted residues of the first metal layer (19) and using the remaining metal silicide layer as the seed layer for the subsequent plating step.

13. A method according to any of the previous claims, wherein said second metal layer (18) is an Al layer, and said peak annealing temperature is about 660°C.

14. A method according to any of the previous claims, wherein said second metal layer (18) is an AISi layer, and said peak annealing temperature is about 570°C.

15. A method according to any of the previous claims, further comprising providing a second dielectric layer on the rear side of the silicon substrate (10) and locally opening the second dielectric layer before providing the second metal layer (18).

## Patentansprüche

1. Verfahren für die Herstellung von Photovoltaikzellen aus kristallinem Silizium, wobei das Verfahren umfasst:
- Bereitstellen einer dielektrischen Schicht (14) auf einer Vorderfläche eines Siliziumsubstrats (10);
- Bilden von Öffnungen durch die dielektrische Schicht (14) hindurch an vorbestimmten Stellen (16), an denen Vorderseitenkontakte (20) für jeweilige Photovoltaikzellen gebildet werden sollen; und
- danach;
∘ Vorsehen einer ersten Metallschicht (19) auf der Vorderseite des Substrats; und
∘ Vorsehen einer zweiten Metallschicht (18) auf der Rückseite des Siliziumsubstrats; und
- danach Glühen mit einer Spitzen-Glühtemperatur, und wobei die erste Metallschicht (19) so ausgewählt wird, dass sie Silizidbildung bei der Spitzen-Glühtemperatur ermöglicht, um dadurch Rückseitenkontakt und Back Surface Field-Regionen (17) an der Rückseite der Zellen zu bilden, und um dadurch gleichzeitig ein Silizid an der Vorderseite an Stellen zu bilden, an denen sich die erste Metallschicht in direktem Kontakt mit dem Siliziumsubstrat befindet; und
- danach Plattieren von mindestens einer weiteren Metallschicht unter Verwendung des Silizids als eine Keimschicht, dadurch Bilden von Vorderseitenkontakten (20).

2. Verfahren nach Anspruch 1, wobei die Spitzen-Glühtemperatur zwischen 570 °C und 830 °C beträgt.

3. Verfahren nach Anspruch 2, wobei die Spitzen-Glühtemperatur unter 800 °C beträgt.

4. Verfahren nach einem der vorstehenden Ansprüche, wobei die dielektrische Schicht (14) eine Antireflexionsbeschichtung ist oder umfasst.

5. Verfahren nach einem der vorstehenden Ansprüche, wobei die dielektrische Schicht (14) eine einzelne dielektrische Schicht ist und eine SiNₓ-Schicht, eine SiOₓ-Schicht oder eine AlOₓ-Schicht umfasst.

6. Verfahren nach einem der vorstehenden Ansprüche 1 bis 4, wobei die dielektrische Schicht (14) ein Stapel dielektrischer Schichten ist, die AlOₓ und/oder SiNₓ und/oder SiOₓ umfassen.

7. Verfahren nach einem der vorstehenden Ansprüche, wobei die dielektrische Schicht (14) Wasserstoff umfasst und Vorderflächenpassivierung vorsieht.

8. Verfahren nach einem der vorstehenden Ansprüche, das das Bilden von Öffnungen durch die dielektrische Schicht (14) hindurch mittels Laserablation umfasst.

9. Verfahren nach einem der vorstehenden Ansprüche, wobei die erste Metallschicht (19) eine Übergangsmetallschicht ist.

10. Verfahren nach einem der vorstehenden Ansprüche 1 bis 7, wobei die erste Metallschicht (19) TiW, TiN oder TaN umfasst.

11. Verfahren nach einem der vorstehenden Ansprüche, wobei die zweite Metallschicht (18) Aluminium umfasst.

12. Verfahren nach einem der vorstehenden Ansprüche, weiter das Entfernen von nicht umgesetzten Resten der ersten Metallschicht (19) und Verwenden der verbleibenden Metallsilizidschicht als die Keimschicht für den anschließenden Plattierungsschritt umfassend.

13. Verfahren nach einem der vorstehenden Ansprüche, wobei die zweite Metallschicht (18) eine Al-Schicht ist, und die Spitzen-Glühtemperatur etwa 660 °C beträgt.

14. Verfahren nach einem der vorstehenden Ansprüche, wobei die zweite Metallschicht (18) eine AlSi-Schicht ist und die Spitzen-Glühtemperatur etwa 570 °C beträgt.

15. Verfahren nach einem der vorstehenden Ansprüche, weiter das Vorsehen einer zweiten dielektrischen Schicht auf der Rückseite des Siliziumsubstrats (10) und stellenweise Öffnen der zweiten dielektrischen Schicht vor dem Vorsehen der zweiten Metallschicht (18) umfassend.

## Revendications

1. Procédé pour la fabrication de cellules photovoltaïques à silicium cristallin, le procédé comprenant :
- la fourniture d'une couche diélectrique (14) sur une surface avant d'un substrat en silicium (10) ;
- la formation d'ouvertures à travers la couche diélectrique (14), à des emplacements prédéterminés (16) où des contacts de côté avant (20) doivent être formés pour des cellules photovoltaïques respectives ; et
- ensuite ;
∘ la fourniture d'une première couche de métal (19) sur le côté avant du substrat ; et
∘ la fourniture d'une seconde couche de métal (18) sur le côté arrière du substrat en silicium ; et
- ensuite, le recuit avec une température de recuit crête et la première couche de métal (19) étant sélectionnée pour permettre la formation de siliciure à la température de recuit crête, pour former ainsi des contacts de côté arrière et des régions de champ de surface arrière (17) du côté arrière des cellules, et pour former ainsi simultanément un siliciure du côté avant à des emplacements où la première couche de métal est en contact direct avec le substrat en silicium ; et
- ensuite, le placage d'au moins une couche de métal supplémentaire à l'aide dudit siliciure en tant que couche de germe, formant ainsi des contacts de côté avant (20).

2. Procédé selon la revendication 1, dans lequel ladite température de recuit crête est comprise entre 570 °C et 830 °C.

3. Procédé selon la revendication 2, dans lequel ladite température de recuit crête est inférieure à 800 °C.

4. Procédé selon l'une quelconque des revendications précédentes, dans lequel ladite couche diélectrique (14) est ou comprend un revêtement antireflet.

5. Procédé selon l'une quelconque des revendications précédentes, dans lequel ladite couche diélectrique (14) est une couche diélectrique unique et comprend une couche de SiNₓ, une couche de SiOₓ ou une couche d'AlOₓ.

6. Procédé selon l'une quelconque des revendications 1 à 4 précédentes, dans lequel ladite couche diélectrique (14) est un empilement de couches diélectriques comprenant AlOₓ et/ou SiNₓ et/ou SiOₓ.

7. Procédé selon l'une quelconque des revendications précédentes, dans lequel ladite couche diélectrique (14) comprend de l'hydrogène et fournit une passivation de surface avant.

8. Procédé selon l'une quelconque des revendications précédentes, comprenant la formation d'ouvertures à travers la couche diélectrique (14) au moyen d'une ablation au laser.

9. Procédé selon l'une quelconque des revendications précédentes, dans lequel la première couche de métal (19) est une couche de métal de transition.

10. Procédé selon l'une quelconque des revendications 1 à 7 précédentes, dans lequel ladite première couche de métal (19) comprend TiW, TiN ou TaN.

11. Procédé selon l'une quelconque des revendications précédentes, dans lequel ladite seconde couche de métal (18) comprend de l'aluminium.

12. Procédé selon l'une quelconque des revendications précédentes, comprenant en outre l'élimination de résidus n'ayant pas réagi de la première couche de métal (19) et l'utilisation de la couche de siliciure de métal restante en tant que couche de germe pour l'étape de placage ultérieure.

13. Procédé selon l'une quelconque des revendications précédentes, dans lequel ladite seconde couche de métal (18) est une couche d'Al, et ladite température de recuit crête est d'environ 660 °C.

14. Procédé selon l'une quelconque des revendications précédentes, dans lequel ladite seconde couche de métal (18) est une couche d'AlSi, et ladite température de recuit crête est d'environ 570 °C.

15. Procédé selon l'une quelconque des revendications précédentes, comprenant en outre la fourniture d'une seconde couche diélectrique sur le côté arrière du substrat en silicium (10) et l'ouverture locale de la seconde couche diélectrique avant de fournir la seconde couche de métal (18).
